# EUROPÄISCHE PATENTANMELDUNG

(11) **EP 1 542 024 A1**
(43) Veröffentlichungstag der Anmeldung: **15.06.2005**
(21) Anmeldenummer: 04028539.7
(22) Anmeldetag: 02.12.2004
(51) Int. Cl.: G01R 11/24, F16B 41/00, G09F 3/03

(54) **Plombierbare Arretierung zur Sicherung der Betriebsposition eines Stromzählers auf einer Trägerplattform**

(30) Priorität: 12.12.2003 DE 10358133; 16.04.2004 DE 4018761
(71) Anmelder: Hager Electro GmbH, 66131 Saarbrücken (DE)
(72) Erfinder: Kelaiditis, Konstantin, Dr., 66386 St. Ingbert (DE); Zimmermann, Michael, 66399 Mandelbachtal (DE); Clemens, Guntram, Dr., 90409 Nürnberg (DE)
(74) Vertreter: Bernhardt, Winfrid, Dr.-Ing.

(57) **Zusammenfassung**

Die Erfindung betrifft eine plombierbare Arretierung zur Sicherung der Betriebsposition eines Stromzählers auf einer Trägerplattform, mit einem zur Arretierung des Stromzählers auf der Trägerplattform in einer Führung am Stromzähler in eine Öffnung (14) an der Trägerplattform (3) vorschiebbaren, in dieser Eingriffsposition plombierbaren Arretierungselement (6). Gemäß der Erfindung ist das Arretierungselement (6) federbeaufschlagt und rastet in der Betriebsposition des Stromzählers selbsttätig in die Öffnung (14) an der Trägerplattform ein und/oder ist zusätzlich zur Plombierung eine das Arretierungselement (5) in der Eingriffsposition haltende, verschließbare Verriegelung (106,107,125,126) vorgesehen.

## Beschreibung

Die Erfindung betrifft eine plombierbare Arretierung zur Sicherung der Betriebsposition eines Stromzählers auf einer Trägerplattform, mit einem zur Arretierung des Stromzählers auf der Trägerplattform in einer Führung am Stromzähler in eine Öffnung an der Trägerplattform vorschiebbaren, in dieser Eingriffsposition plombierbaren Arretierungsetement.

Eine solche Plombierung ist aus der DE 100 52 998 A1 bekannt. Als Arretierungselement dient ein das Stromzählergehäuse durchsetzender Stift, der in die Öffnung in der Trägerplattform eingreift und der plombierbar ist, so dass seine Verschiebungsposition in bezug auf das Stromzählergehäuse nicht verändert und der durch den Stift arretierte Zähler auf der Trägerplattform nicht verschoben werden kann.

Der vorliegenden Erfindung liegt die Aufgabe zugrunde, eine neue plombierbare Arretierung zur Sicherung der Betriebsposition eines Stromzählers auf einer Trägerplattform der eingangs erwähnten Art zu schaffen, durch welche ein manipulationssicherer Anschluss von Strömzählern an die Trägerplattform erleichtert wird.

Diese Aufgabe wird durch die im Anspruch 1 angegebenen Merkmale gelöst.

In einer Ausführungsform der Erfindung ist das Arretierungselement federbeaufschlagt und rastet in der Betriebsposition des Stromzählers selbsttätig in die Öffnung an der Trägerplattform ein.

Vorteilhaft bedarf es zum Vorschieben des Arretierungselements in die Öffnung keines gesonderten Montagearbeitsgangs. Nach selbsttätigem Einrasten des Elements in die Arretierungsstellung braucht nur noch eine Plombierung des Arretierungselements, z.B. durch einen Plombierdraht, zu erfolgen.

Das Arretierungselement liegt in der vorgeschobenen Arretierungsposition zweckmäßig gegen einen am Stromzählergehäuse gebildeten Anschlag an. Dies macht es möglich, das Arretierungselement unabhängig von der Trägerplattform am Stromzähler vorzumontieren, wobei es durch die Federbeaufschlagung stets, relativ zum Stromzählergehäuse, in der Arretierungsstellung gehalten wird.

Das vorzugsweise stiftförmige, in einem Durchgang im Stromzählergehäuse aufgenommene Arretierungselement schließt in einer besonders bevorzugten Ausführungsform der Erfindung in der Arretierungsstellung bündig mit dem vorderen Öffnungsrand des Durchgangs am Stromzählergehäuse ab. So steht das Arretierungselement auf der Vorderseite des Zählergehäuses nicht vor, was die Verpackung und den Transport von Zählern mit vorinstalliertem Arretierungselement erleichtert.

Vorzugsweise bildet das bündig mit dem Öffnungsrand abschließende Arretierungselement mit der an den Öffnungsrand angrenzenden Wand des Stromzählergehäuses eine ebene Fläche. Dies erlaubt es, ein Plombierelement in Form einer auf das Arretierungselement und die umgebende Wand aufgeklebten Folie zu verwenden.

Bei der Feder handelt es sich vorzugsweise um eine den Arretierungsstift umgebende Schraubenfeder. Zweckmäßig ist die Schraubenfeder an der rückseitigen Öffnung des Durchgangs angeordnet, wo sie sich leicht montieren und demontieren lässt. Die Drahtenden der Schraubenfeder können jeweils in eine Öffnung am Stromzählergehäuse und eine Öffnung am Arretierungselement eingeführt und dadurch an den genannten Teilen festgelegt sein.

In weiterer vorteilhafter Ausgestaltung der Erfindung ist ein Gewinde- oder Wendelgang gebildet, durch den eine Rückverschiebung des Arretierungselements unter Freigabe des Stromzählers zur Verschiebung aus der Betriebsposition durch Drehung des Arretierungselements möglich ist. Der Gewinde- oder Wendelgang kann in dem Durchgang gebildet sein. Der Gewinde- bzw. Wendelgang weist zweckmäßig eine so hohe Steigung auf, so dass durch eine Drehung um einen Winkel kleiner 360° bereits eine zur Entriegelung des Zählers ausreichende Hubhöhe des Arretierungselements erreicht wird. Ferner kann ein die Drehung des Arretierungselements begrenzender Anschlag gebildet sein.

In einer Ausführungsform der Erfindung kann das Arretierungselement mehrteilig ausgebildet sein, wobei zwischen den Teilen eine einrastende Formschlussverbindung hergestellt ist. Ein solches Element lässt sich leicht am Stromzähler montieren.

Das Arretierungselement kann eine Sollbruch- oder Schraubverbindungsstelle aufweisen. Für den Fall, dass eine besondere Sicherung eines Zählers notwendig erscheint, kann das Element zertrennt und der vordere Teil weiterverwendet werden, während in dem frei gewordenen hinteren Teil des Durchgangs ein Steckschloss einsetzbar ist.

In weiterer Ausgestaltung der Erfindung ist der Durchgang nahe einer Seitenwand des Gehäuses angeordnet, wobei die Seitenwand des Gehäuses vorteilhaft einen Wandteil des Durchgangs bilden kann.

In dieser Ausführungsform lässt sich ein zur Seitenwand des Stromzählergehäuses öffnender Kanal für einen Plombierungsdraht bilden. Eine solche Anordnung des Kanals erleichtert die Verlegung des Plombierungsdrahtes. Die obengenannte Drehung zum Lösen des Arretierungselements aus der Arretierungsstellung erhöht die Plombiersicherheit, indem durch die Drehung mehr Plombierdraht "verbraucht" wird.

In einer alternativen Ausführungsform der Erfindung einer in Kombination mit den vorangehend beschriebenen Ausführungsformen kann zusätzlich zur Plombierung eine das Arretierungselement in der Eingriffsposition haltende, verschließbare Verriegelung vorgesehen sein.

Durch eine solche Verriegelung lassen sich Manipulationen an der Stromzähleranlage weiter erschweren.

In einer bevorzugten Ausgestaltung umfasst die Verriegelung ein in einen Aufnahmeschacht am Stromzählergehäuse einsetzbares Steckschloss mit einem in eine Halteposition bewegbaren, vorzugsweise verschwenkbaren, Riegelelement.

Das Riegelelement, z.B. ein verschwenkbarer Abschnitt eines Bartansatzes eines Steckschlosses, kann in eine Ausnehmung in dem Arretierungselement einschwenkbar sein. Hierzu kann eine Ausnehmung genutzt werden, die zur Meidung von Materialhäufungen ohnehin vorgesehen sein muß.

In der bevorzugten Ausgestaltung umfasst das Arretierungselement einen Arretierungsstift, der in einem das Gehäuse des Stromzählers durchsetzenden röhrenförmigen Führungskanal angeordnet ist.

Vorzugsweise erfordert die Rückbewegung des Arretierungselements aus der Eingriffsposition eine Drehung des Arretierungselements. Entsprechend ist am Arretierungselement und der Führung jeweils ein Gewinde- bzw. Wendelgang vorgesehen. Vorzugsweise ist die Gewindesteigung so bemessen, dass sich der vorstehende Arretierungsstift beim Aufsetzen des Stromzählergehäuses auf die genannte Trägerplattform von selbst unter Drehung innerhalb der Führung zurückverschiebt. Bei einer solchen Arretierung ist das Riegelelement vorzugsweise zur Drehblockierung des Arretierungselements vorgesehen. Da eine Translationsbewegung des Arretierungsstifts an eine Drehbewegung verkoppelt ist, kann die Translationsbewegung bei Drehblockierung nicht erfolgen und das Arretierungselement verbleibt, wie gewünscht, in der Eingriffsposition.

In weiterer vorteilhafter Ausgestaltung der Erfindung verläuft die Schwenkachse des Riegelelements parallel zur Längsachse bzw. Drehachse des Arretierungselements. Das Steckschloss wird also neben der Öffnung für den Arretierungsstift in einem neben dem Führungskanal für den Arretierungsstift angeordneten Aufnahmeschacht versenkt.

Vorzugsweise ist zwischen dem Aufnahmeschacht und dem röhrenförmigen Führungskanal ein gegen den Innenraum des Zählergehäuses abgeschlossener Durchgang für das Riegelelement gebildet. Somit besteht keine Möglichkeit, durch den Aufnahmeschacht hindurch mit irgendeinem Werkzeug in den Innenraum des Stromzählergehäuses vorzudringen.

In weiterer Ausgestaltung der Erfindung steht von einer vorderen Wand des Stromzählergehäuses ein Ansatz zur Bildung des Führungskanals und des Aufnahmeschachts vor. Die Fortsetzung des Führungskanals kann durch einen weiteren Ansatz gebildet sein, welcher von einer hinteren Wand des Stromzählergehäuses dem genannten Ansatz entgegensteht, wobei letzterer Ansatz gleichzeitig zum Verschließen des Aufnahmeschachts gegen den Innenraum des Stromzählergehäuses dienen kann.

In einer weiteren Ausführungsform der Erfindung ist der Aufnahmeschacht für das Steckschloss über seine gesamte Länge zum Führungskanal für den Arretierungsstift hin geöffnet. Indem der Arretierungsstift durch das Riegelelement des Steckschlosses drehblockiert ist, lässt sich der Arretierungsstift nicht translatorisch in dem Führungskanal bewegen und somit auch das Steckschloss nicht aus dem Aufnahmeschacht herausziehen. Der Arretierungsstift verbleibt in der gewünschten Eingriffsposition. In dieser Ausführungsform kann ein den Aufnahmeschacht gegen den Innenraum des Stromzählergehäuses abschließendes Verschlussstück einstückig mit der vorderen Gehäusewand verbunden sein. Vorteilhaft lässt sich ein vorderer und ein hinterer Teil des Stromzählergehäuses derart ausbilden, dass eine Flanke eines im Führungskanal gebildeten Gewindegangs durch den vorderen Gehäuseteil und die andere Flanke durch den hinteren Gehäuseteil gebildet ist, wobei sich der Gewindegang über nicht mehr als 180° zu erstrecken braucht.

Die Erfindung soll nun anhand von Ausführungsbeispielen und der beiliegenden, sich auf diese Ausführungsbeispiele beziehenden Zeichnungen näher erläutert werden. Es zeigen:
- Fig. 1: ein erstes Ausführungsbeispiel für eine plombierbare Arretierung nach der Erfindung mit einem einteiligen Arretierungsstift,
- Fig. 2: ein zweites Ausführungsbeispiel für eine plombierbare Arretierung nach der Erfindung mit einem zweiteiligen Arretierungsstift,
- Fig. 3: eine Querschnittsansicht gemäß Schnitt I-I von Fig. 2,
- Fig. 4: eine perspektivische Teilansicht eines Stromzählergehäuses mit einer plombierbaren Arretierung nach der Erfindung,
- Fig. 5: eine geschnittene Teilansicht des Stromzählergehäuses von Fig. 4,
- Fig. 6: eine weitere geschnittene Teilansicht des Stromzählergehäuses von Fig. 4 mit der Arretierung nach der Erfindung,
- Fig. 7: eine weitere geschnittene Teilansicht des Stromzählergehäuses von Fig. 4, welche Führungen für einen Arretierungsstift und einen Aufnahmeschacht für ein Steckschloss zeigt, und
- Fig. 8 und 9: Teilansichten eines Stromzählergehäuses mit einer plombierbaren Arretierung gemäß einem weiteren Ausführungsbeispiel nach der Erfindung.

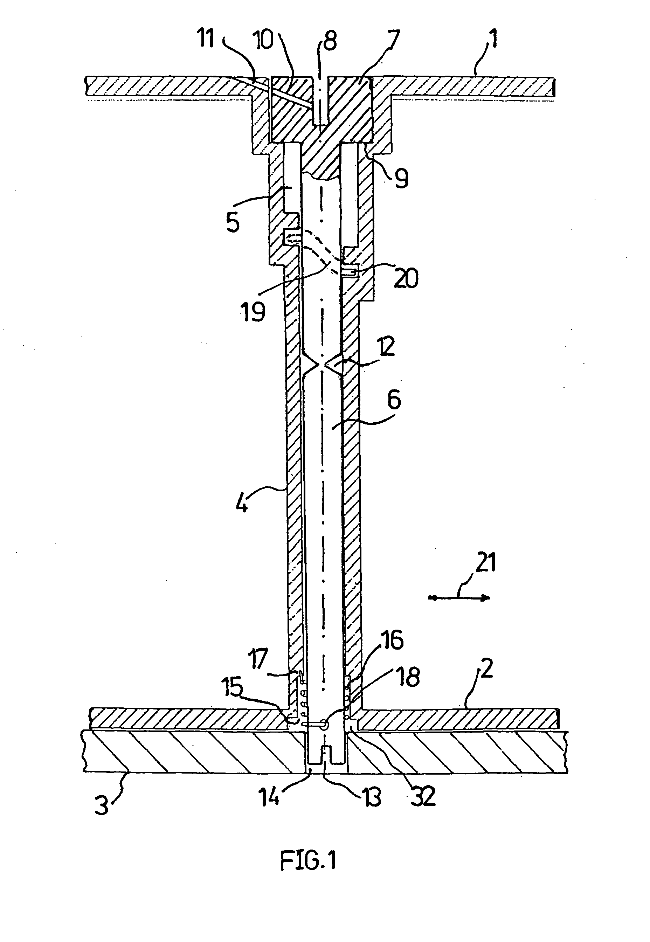

Fig. 1 zeigt einen Ausschnitt aus einem quaderförmigen Stromzählergehäuse mit einer Vorderwand 1 und einer Rückwand 2. Das Stromzählergehäuse liegt mit der Rückwand 2 gegen eine ausschnittsweise dargestellte Platte 3 einer den Stromzähler aufnehmenden Trägerplattform an. Von der Rückwand 2 des Zählergehäuses stehen nicht gezeigte Kontaktstücke und Verhakungselemente vor, welche durch in der Zeichnung ebenfalls nicht sichtbare Öffnungen in der Platte 3 geführt sind, um den Zähler elektrisch und mechanisch mit der Trägerplattform zu verbinden.

Zwischen der Vorderwand 1 und der Rückwand 2 des Stromzählergehäuses erstreckt sich ein mit der Vorder- und Rückwand einstückig verbundenes Hülsenteil 4, welches einen Durchgang 5 für die Aufnahme eines in dem Durchgang verschiebbaren Arretierungsstifts 6 bildet.

Der Arretierungsstift 6 weist einen Kopf 7 mit einem Schlitz 8 für den Eingriff eines Schraubendrehers auf. In der in Fig. 1 gezeigten Stellung liegt der Kopf 7 gegen eine in dem Durchgang 5 gebildete Ringschulter 9 an. Ferner ist in der gezeigten Stellung ein in dem Kopf 7 des Arretierungsstiftes 6 gebildeter Kanal 10 zu einem Kanal 11 in der Gehäusewand 3 ausgerichtet, so dass durch die Kanäle 10 und 11 ein Plombierdraht hindurchgeführt werden kann. Der Kopf 7 des Arretierungsstifts 6 schließt bündig mit der Außenoberfläche der Vorderwand 1 des Stromzählergehäuses ab und der Kopf füllt die vordere Öffnung des Durchgangs 5 vollständig aus, so dass nur ein dünner Spalt zwischen dem Kopf und dem angrenzenden Gehäuse gebildet ist. Der Kopf 7 und die ihn umgebende Wand 3 bilden eine ebene, nur durch den dünnen Spalt unterbrochene Außenfläche.

Wie Fig. 1 ferner zu entnehmen ist, weist der Arretierungsstift 6 etwa in seiner Längsmitte eine Schwachstelle 12 auf.

An seinem der Platte 3 zugewandten Ende ist ein Schlitz 13 für den Eingriff eines Schraubendrehers gebildet. In der gezeigten Position, die der Arretierungsposition entspricht, greift das betreffende Ende des Arretierungsstifts 6 in eine Öffnung 14 in der Platte 3 ein.

In einer an der rückseitigen Öffnung des Durchgangs 5 gebildeten Einsenkung 15 ist eine den Arretierungsstift 6 umgebende Schraubenfeder 16 angeordnet. Ein Federdrahtende der Schraubenfeder 16 greift bei 17 in ein in dem Hülsenteil 4 gebildetes Loch ein. Das andere Federdrahtende ist in einem in dem Arretierungsstift 6 gebildeten Loch 18 festgelegt. Die Einsenkung 15 ist an ihrem offenen Ende bei 32 aufgeweitet, wodurch Platz geschaffen ist, der die Montage und Demontage der Schraubenfeder 16 erleichtert.

Zwischen dem Kopf 7 des Arretierungsstifts 6 und der Schwachstelle 12 ist in dem Durchgang 5 ein Gewindegang 19 gebildet, in welchen ein mit dem Arretierungsstift 6 verbundener Zapfen 20 eingreift. In dem betreffenden Ausführungsbeispiel erstreckt sich der Gewindegang über einen Umfangswinkel von 170°. An seinem oberen Ende geht der Gewindegang 19 in einen in Fig. 1 nicht sichtbaren, nach vom offenen Gangabschnitt für den Zapfen Abschnitt über, der in einer zur Drehachse des Arretierungsstifts 6 senkrechten Ebene liegt. Schließlich ist am Ende dieses Gangabschnitts ein die Drehung des Arretierungsstifts begrenzender Anschlag gebildet.

Im Anlieferungszustand des Stromzählers vor dem Anschluss an die Trägerplattform ist der Arretierungsstift durch die Feder 16 in der in Fig. 1 gezeigten Stellung gehalten, in welcher der Kopf 7 bündig mit der Vorderwand 1 abschließt. Beim Aufsetzen des Zählers auf die Trägerplattform wird der Arretierungsstift 6 durch die Platte 3 gegen die Kraft der Feder 16 in Richtung zur Vorderwand 1 verschoben. Die große Steilheit des Gewindegangs 19 lässt eine solche Verschiebung zu.

Zum Anschluss des Stromzählers an die Zählerplattform erfolgt eine Verschiebung des auf die Platte 3 aufgesetzten Stromzählers gemäß Pfeil 21. Der Arretierungsstift 6 wird währenddessen durch die Platte 3 weiterhin zurückgehalten. Wenn die Öffnung 14 erreicht ist, rastet er dort ein. Auch diese Bewegung lässt der steile Gewindegang 19 zu. Durch die in dieser Raststellung zueinander ausgerichteten Kanäle 10 und 11 kann nun ein Plombierdraht gelegt und der Arretierungsstift 6 plombiert werden.

Anstelle der Sicherung mittels Plombierdraht und Plombe könnte über dem Arretierungsstift 6, der bündig mit der Vorderwand 1 des Stromzählergehäuses abschließt, auch eine Plombiermarke in Form einer Folie auf die Wand 1 aufgeklebt werden.

Der Arretierungsstift lässt sich nur durch Drehung aus der Arretierungsstellung lösen, was mit hohem Plombierdrahtverbrauch und damit hoher Sicherheit der Plombierung verbunden ist. Zur Lösung der Arretierung ist der Arretierungsstift mittels Schraubendreher zu drehen. Am Ende des Hubs gelangt der Arretierungsstift wieder in eine Arretierungsposition. In dieser Position liegt der Zapfen 20 auf dem zur Drehachse senkrecht verlaufenden Abschnitt auf.

Stellt das Stromversorgungsuntemehmen fest, dass an der Verplombung manipuliert wurde, so besteht die Möglichkeit, die Sicherung des Stromzählers zu verschärfen, indem der Arretierungsstift 6 demontiert und an der Sollbruchstelle 12 in zwei Teile zerlegt wird. Anstelle des die Feder 16 aufweisenden Teils kann dann ein Steckschloss eingesetzt und der den Kopf aufweisende Teil des Arretierungsstifts weiterverwendet werden.

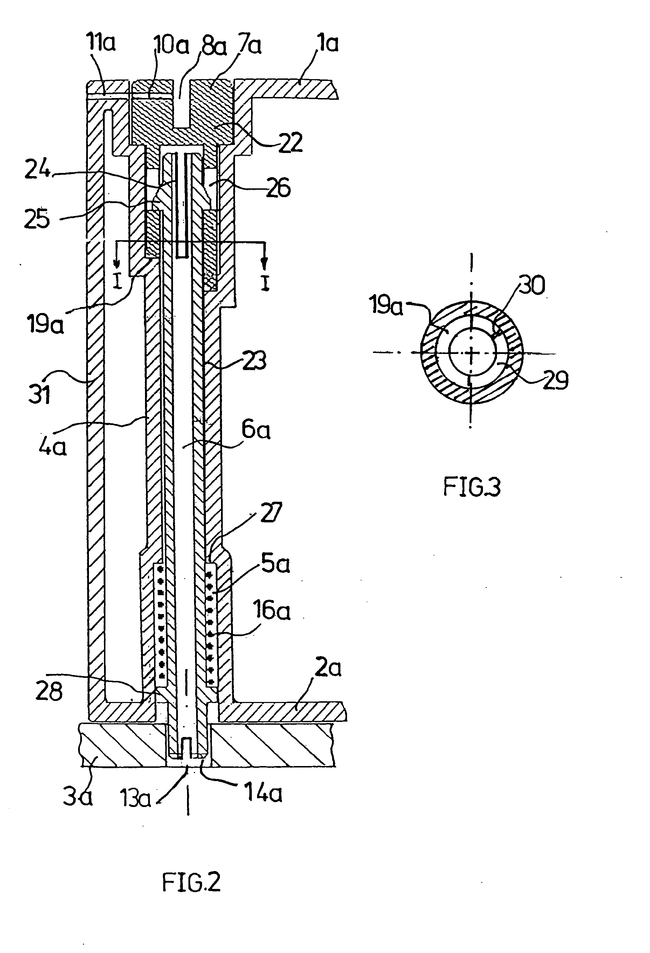

In Fig. 2 sind gleiche oder gleichwirkende Teile mit derselben Bezugszahl wie in Fig. 1 bezeichnet, wobei der betreffenden Bezugszahl jeweils der Buchstabe a beigefügt ist.

Das Ausführungsbeispiel von Fig. 2 unterscheidet sich von dem Ausführungsbeispiel von Fig. 1 dadurch, dass ein in einem Durchgang 5a aufgenommener Arretierungsstift 6a zweiteilig mit einem einen Kopf 7a aufweisenden vorderen Teil 22 und einem hinteren Teil 23 hergestellt ist. Der vordere Teil 22 ist hinter dem Kopf 7a als einseitig offener Hohlkörper ausgebildet, in welchen der hintere Teil 23 des Arretierungsstifts eingeführt ist. Wie Fig. 2 erkennen lässt, weist der hintere Teil 23 an seinem dem vorderen Teil 22 zugewandten Ende eine Einschlitzung 24 auf. Durch die Einschlitzung sind biegbare Schenkel mit jeweils einer Rastnase 25 gebildet, welche in eine Rastöffnung 26 in dem vorderen Teil 22 des Arretierungsstifts einrasten kann.

Eine Feder 16a an den dem Kopf 7a abgewandten Ende des Arretierungsstifts 6a liegt mit einem Federende gegen eine Ringschulter 27 in dem Durchgang 5a an. Das andere Federende ist durch eine am Arretierungsstift gebildete Ringaufweitung 28 abgestützt.

Der Durchgang 5a weist in einem den oberen Teil 22 des Arretierungsstifts aufnehmenden Abschnitt einen Wendelgang 19a auf, der sich in dem gezeigten Ausführungsbeispiel über einen Winkel von 180° erstreckt. Gegen den Wendelgang liegt in der in Fig. 2 gezeigten Position des Arretierungsstifts eine entsprechend geformte Endstirnfläche des vorderen Teils 22 des Arretierungsstifts an.

Wie Fig. 3 erkennen lässt, geht der Wendelgang in einen zur Stiftachse senkrechten Teil 29 über, in welchem eine Rastvertiefung 30 für den Eingriff durch das Ende des vorderen Teils 22 des Arretierungsstifts gebildet ist.

Bei dem in Fig. 2 gezeigten Ausführungsbeispiel ist der Durchgang 5a nahe einer Seitenwand 31 eines Stromzählergehäuses gebildet und ein Kanal 11a für die Aufnahme eines Plombierdrahts öffnet zu dieser Seitenwand 31.

In der in Fig. 2 gezeigten Plombierstellung ist der Kanal 11 a zu einem Kanal 10a im Kopf 7a des Arretierungsstifts 6a ausgerichtet, und es kann ein Plombierdraht durch die Kanäle hindurchgeführt werden.

Zur Lösung des Arretierungsstifts aus der Arretierungsposition kann eine Drehung erfolgen, wobei der Stift 6a einer Öffnung 14a zurückgezogen und die Feder 16a gespannt wird. In dem betreffenden Ausführungsbeispiel ist die Feder 16a stärker als die Feder 16 in dem vorangehenden Ausführungsbeispiel ausgebildet. Dafür ist keine mechanische Sperre vorgesehen, die es verhindert, den Stift ohne Drehung aus der Arretierungsposition zurückzuziehen.

Der Arretierungsstift 6a ist wie der Stift von Fig. 1 in zwei Teile zerlegbar, indem unter Nutzung von Einschlitzungen 8a und 13a an den Enden die beiden Teile gegeneinander verdreht werden, wobei die Rastnasen 25 nach innen aus den Rastöffnungen herausgedrückt werden. Geeignete Abschrägungen an den Nasen oder Öffnungen können dies erleichtern. Auch der Arretierungsstift 6a könnte eine Schwachstelle aufweisen.

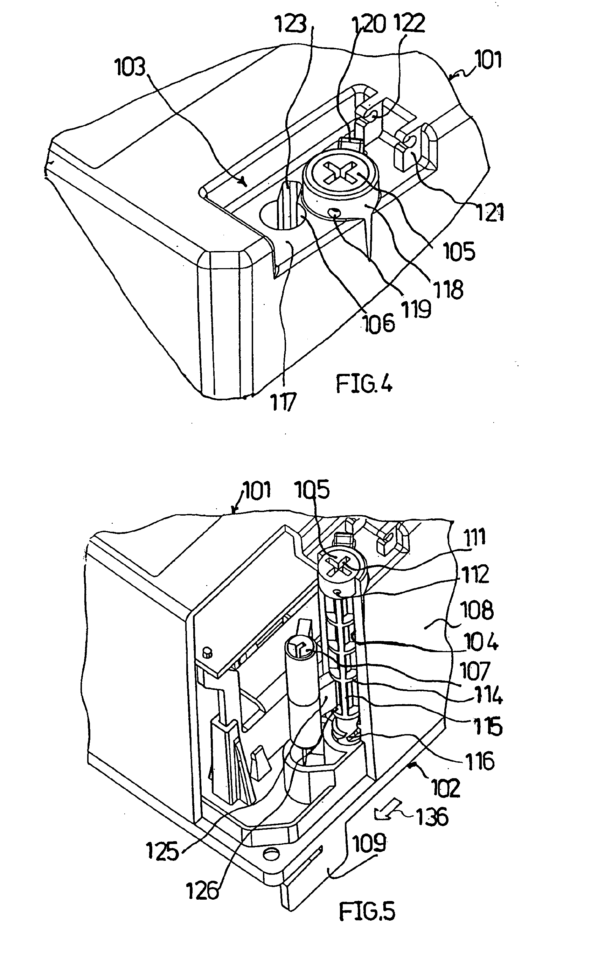

Ein in Fig. 4 gezeigtes Stromzählergehäuse mit einem oberen Gehäuseteil 101 und einem unteren Gehäuseteil 102 weist am Rand der Oberseite des oberen Gehäuseteils 101 eine rechteckige, an einer Rechteckseite offene Einsenkung 103 auf. Im Bereich der Einsenkung 103 münden zur Oberseite des oberen Gehäuseteils 101 ein Führungskanal 104 für einen Arretierungsstift 105 sowie ein Aufnahmeschacht 106 für ein Steckschloss 107. Der Führungskanal 104 für den Arretierungsstift 105 ist einstückig an eine Seitenwand 108 des oberen Gehäuseteils 101 angeformt.

An den unteren Gehäuseteil 102 sind an allen vier Ecken Hakenelemente 109 angeformt, welche in Schlitze in einer in Fig. 4 gezeigten Trägerplattform 132 einsteckbar sind. Durch Verschiebung gemäß Pfeil 136 lässt sich das Zählergehäuse an der Trägerplattform verriegeln und mit Hilfe des Arretierungsstifts 105, welcher in der Verriegelungsstellung des Gehäuses in eine Öffnung 133 in der Trägerplattform 132 eingreift, arretieren.

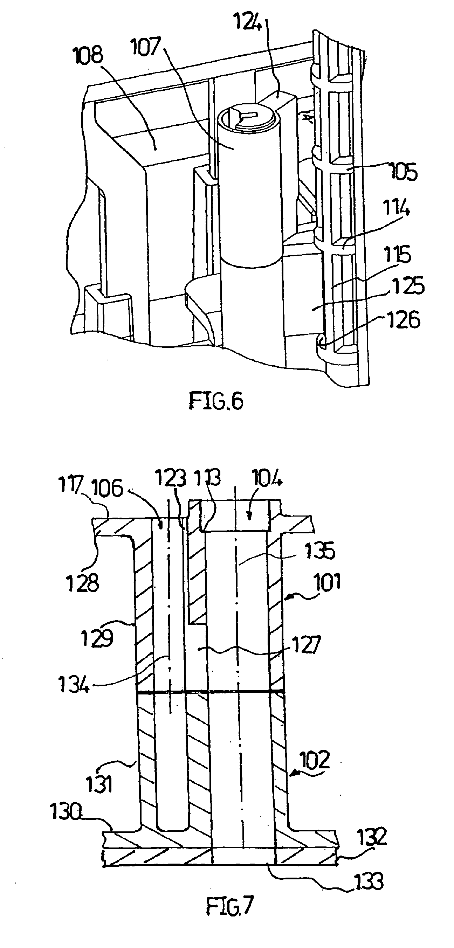

Wie insbesondere Fig. 5 erkennen lässt, weist der Arretierungsstift 105 einen Kopf 110 mit einem Kreuzschlitz 111 und einem Durchgang 112 für einen Plombierdraht auf. In der Arretierungsposition schlägt der Kopf 110 gegen eine in dem Führungskanal 104 gebildete Ringschulter 113 an. Der Stift weist in seinem Mittelabschnitt eine Struktur aus Ringen und Längsstegen auf, durch welche gegenüber einem vollzylindrischen Stift Materialhäufungen vermieden werden.

An den Ringe und Längsstege aufweisenden Abschnitt des Arretierungsstifts 105 schließt sich ein Wendelgang 116 an, in welchen ein in dem Führungskanal 104 gebildeter, in den Figuren nicht gezeigtes Gegengewinde eingreift. Anschließend an den Wendelgang setzt sich, in den Figuren nicht sichtbar, der Arretierungsstift 105 mit einem Endstück fort, welches in die Öffnung 133 in der Trägerplattform 132 eingreift und zur Erhöhung der Scherfestigkeit eine zentrale Metalleinlage aufweist.

Während der Aufnahmeschacht 106 für das Steckschloss 107 unmittelbar zur Bodenfläche 117 der Einsenkung 103 hin öffnet, ist der Führungskanal 104 durch einen Ringvorsprung 118 verlängert, welcher zwei diametral angeordnete Durchgänge 119 für den obengenannten Plombierdraht aufweist. Ausgerichtet zu einem der Durchgänge 119 steht von der Bodenfläche 117 eine Rampe 120 zur Führung des durch den Durchgang 112 und die Durchgänge 119 geführten Plombierdrahtes vor.

Zwei vorstehende Trägerböcke 121 mit je einer Achslagerung 122 dienen der Halterung einer die Einsenkung 103 bündig abdeckenden, mit einer entsprechenden Drehachse versehenen Klappe (nicht gezeigt). Die genannte Klappe bzw. dessen Drehachse lässt sich auf die Trägerböcke 121 aufstecken.

Wie Fig. 4 und 7 erkennen lassen, weist der Aufnahmeschacht 106 eine stegförmige Aufweitung 123 für die Aufnahme eines mit dem rundzylindrischen Teil des Steckschlosses 107 verbundenen Bartansatzes 124 auf. Ein Abschnitt 125 des Bartansatzes 124, welcher ein Riegelelement bildet, ist durch Betätigung des Steckschlosses 107 in eine Ausnehmung 126 des Arretierungsstifts 105 einschwenkbar, wobei die Ausnehmung 126 durch die genannte Ring- und Stegstruktur des Arretierungsstifts gebildet ist.

Um den Abschnitt 125 des Bartansatzes 124 in die Ausnehmung 126 einschwenken zu können, ist zwischen dem Aufnahmeschacht 106 und dem Führungskanal 104 bei 127 ein entsprechender Durchgang gebildet.

Wie Fig. 7 erkennen lässt, ist zur Bildung des Führungskanals 104 und des Aufnahmeschachts 106 ein von der vorderen Gehäusewand 128 vorstehender Ansatz 129 gebildet. Dem Ansatz 129 kommt von der hinteren Gehäusewand 130 ein Ansatz 131 entgegen. Durch den Ansatz 131 wird einerseits der Führungskanal 104 über den Ansatz 131 hinaus verlängert und andererseits der Aufnahmeschacht 106 gegen den Innenraum des Stromzählergehäuses abgeschlossen.

Bei der Montage eines Stromzählers an der Trägerplattform 132 werden die Hakenelemente 109 in die genannten Schlitze senkrecht zur Trägerplattform eingeschoben und der Zähler durch Verschiebung in Richtung des Pfeils 136 verriegelt. Die Steigung des Wendelgangs 116 ist so bemessen, dass sich der vormontierte, vom Stromzählergehäuse nach hinten vorstehende Arretierungsstift 105 beim Aufsetzen auf die Trägerplattform 132 selbsttätig unter Drehung im Führungskanal 104 zurückverschiebt. In der Verriegelungsposition lässt sich der Arretierungsstift 105 unter Drehung axial vorschieben, so dass das Ende des Arretierungsstifts 5 in die Öffnung 133 der Trägerplattform 132 hinein vorsteht. In dieser Position schließt der Kopf 110 bündig mit dem Ringvorsprung 118 ab und die Durchgänge 119 in dem Ringvorsprung 118 sind ausgerichtet zu dem Durchgang in dem Kopf 110. Somit lässt sich ein Plombierdraht durch die genannten Durchgänge führen, welcher beim Anstoß gegen die Rampe 120 nach oben abgebogen wird und so bequem gehandhabt werden kann. Nach der Plombierung wird die genannte Abdeckung umgeklappt. Die zum Stromzählergehäuse bündige Abdeckung lässt sich zur weiteren Sicherung des Stromzählers mit einer Plombierfolie überkleben.

In bestimmten Fällen kann eine zusätzliche Sicherung durch das Steckschloss 107 erfolgen, welches in den Aufnahmeschacht 106 eingesteckt wird. Beim Verschließen tritt der Abschnitt 125 des Bartansatzes 124 in die Ausnehmung 116 und sorgt für eine Drehblockierung des Arretierungsstifts 105. Da zur axialen Bewegung des Arretierungsstifts eine Drehung erforderlich ist, kann der Arretierungsstift somit nicht aus seiner Arretierungsstellung, in welcher er in die Öffnung 133 eingreift, herausbewegt werden. Die Aufweitung 123 ist nahe am Führungskanal angeordnet, so dass nur ein kleiner Schwenkwinkel erforderlich ist.

Abweichend von dem gezeigten Ausführungsbeispiel könnte zusätzlich eine Torsionsschraubenfeder an dem Arretierungsstift angebracht sein, der dafür sorgt, dass der Arretierungsstift selbsttätig unter Drehung in die Arretierungsposition vorrückt.

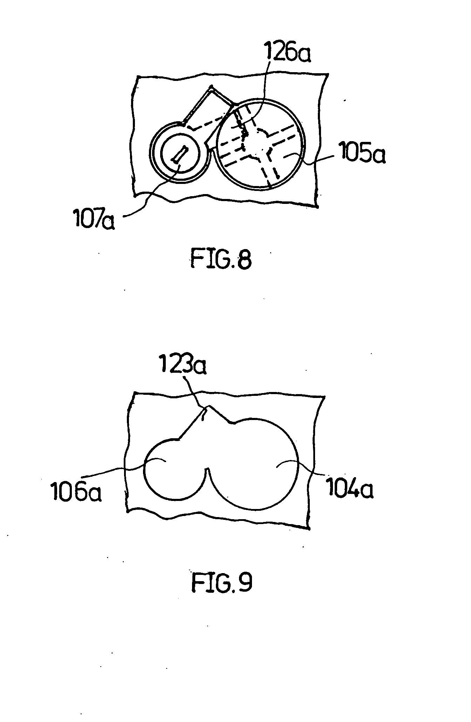

Bei dem Ausführungsbeispiel gemäß den Fig. 8 und 9 ist ein Aufnahmeschacht 106a für ein Steckschloss 107a zu einem benachbarten Führungskanal für einen Arretierungsstift 105a hin über seine gesamte Länge offen. Ein gegen den Innenraum des Stromzählergehäuses verschlossener Aufnahmeschacht lässt sich bei diesem Ausführungsbeispiel mit Hilfe eines einfachen Spritzwerkzeugs einstückig an die Vorderwand des Stromzählergehäuses anformen. Ein vorderes und hinteres Werkzeugteil kann so hergestellt werden, dass eine Gewindeflanke eines in dem Führungskanal 104a vorgesehenen Gewindes durch den vorderen Werkzeugteil und die andere Gewindeflanke durch den hinteren Werkzeugteil gebildet wird.

## Patentansprüche

1. Plombierbare Arretierung zur Sicherung der Betriebsposition eines Stromzählers auf einer Trägerplattform, mit einem zur Arretierung des Stromzählers auf der Trägerplattform in einer Führung am Stromzähler in eine Öffnung (14) an der Trägerplattform (3) vorschiebbaren, in dieser Eingriffsposition plombierbaren Arretierungselement (6),
**dadurch gekennzeichnet,**
**dass** das Arretierungselement (6) federbeaufschlagt ist und in der Betriebsposition des Stromzählers selbsttätig in die Öffnung (14) an der Trägerplattform einrastet und/oder dass zusätzlich zur Plombierung eine das Arretierungselement (5) in der Eingriffsposition haltende, verschließbare Verriegelung (106,107,125,126) vorgesehen ist.

2. Arretierung nach Anspruch 1,
**dadurch gekennzeichnet,**
**dass** das Arretierungselement (6) einen das Gehäuse (1,2; 1a,2a,31) des Stromzählers durchsetzenden Arretierungsstift (6,6a) umfasst.

3. Arretierung nach Anspruch 1 oder 2,
**dadurch gekennzeichnet,**
**dass** der Stromzähler einen die Führung bildenden, zur Vor- und Rückseite des Stromzählers offenen Durchgang (5) für die Aufnahme des Arretierungselements (6) aufweist.

4. Arretierung nach einem der Ansprüche 1 bis 3,
**dadurch gekennzeichnet,**
**dass** das Arretierungselement (6) in der vorgeschobenen Arretierungsposition bündig mit dem Rand der vorderen Öffnung des Durchgangs (5) abschließt.

5. Arretierung nach Anspruch 4,
**dadurch gekennzeichnet,**
**dass** das bündig mit dem Öffnungsrand abschließende Arretierungselement (6) mit der an den Öffnungsrand angrenzenden Wand (1) des Stromzählergehäuses eine ebene Fläche bildet.

6. Arretierung nach einem der Ansprüche 2 bis 5,
**dadurch gekennzeichnet,**
**dass** zur Beaufschlagung des Arretierungsstifts (6) eine den Arretierungsstift umgebende Schraubenfeder (16) vorgesehen ist.

7. Arretierung nach Anspruch 6,
**dadurch gekennzeichnet,**
**dass** die Schraubenfeder (7) an der hinteren Öffnung des Durchgangs (5) angeordnet ist.

8. Arretierung nach einem der Ansprüche 1 bis 7,
**dadurch gekennzeichnet,**
**dass** das Arretierungselement (6) in der vorgeschobenen Arretierungsposition gegen einen am Stromzähler gebildeten Anschlag (9) anliegt.

9. Arretierung nach einem der Ansprüche 1 bis 8,
**dadurch gekennzeichnet,**
**dass** ein Gewinde- oder Wendelgang (19,19a) zur Rückverschiebung des Arretierungselements (6) aus der vorgeschobenen Arretierungsposition durch Drehung des Arretierungselements (6) vorgesehen ist.

10. Arretierung nach Anspruch 9,
**dadurch gekennzeichnet,**
**dass** sich der Gewinde- oder Wendelgang (19,19a) über einen Umfangswinkel erstreckt, der kleiner als 360° ist.

11. Arretierung nach Anspruch 9 oder 10,
**dadurch gekennzeichnet,**
**dass** der Gewinde- oder Wendelgang (19,19a) an der Wand des Durchgangs (5) gebildet ist.

12. Arretierung nach einem der Ansprüche 9 bis 11,
**dadurch gekennzeichnet,**
**dass** der Gewindegang (19) eine solche Steigung aufweist, dass sich das Arretierungselement (6) durch eine axiale Kraft gegen die Federkraft aus der Arretierungsposition rückverschieben lässt.

13. Arretierung nach einem der Ansprüche 9 bis 12,
**dadurch gekennzeichnet,**
**dass** das Arretierungselement durch Drehung in eine weitere Arretierungsposition, in welcher er gegen die Federkraft axial gehalten ist, rückverschiebbar ist.

14. Arretierung nach einem der Ansprüche 6 bis 13,
**dadurch gekennzeichnet,**
**dass** die Enden des Schraubenfederdrahtes zur Festlegung der Schraubenfeder (16) in eine Öffnung (17) am Stromzählergehäuse und in eine Öffnung (18) am Arretierungselement eingeführt sind.

15. Arretierung nach einem der Ansprüche 1 bis 14,
**dadurch gekennzeichnet,**
**dass** das Arretierungselement teilbar und anstelle des einrastenden Teils ein Steckschloss vorgesehen ist.

16. Arretierung nach einem der Ansprüche 1 bis 15,
**dadurch gekennzeichnet,**
**dass** das Arretierungselement (6a) mehrteilig mit einer einrastenden Formschlussverbindung zwischen den Teilen (22,23) hergestellt ist.

17. Arretierung nach einem der Ansprüche 1 bis 16,
**dadurch gekennzeichnet,**
**dass** das Arretierungselement eine Schwachstelle (12) oder eine Schraubverbindungsstelle aufweist.

18. Arretierung nach einem der Ansprüche 3 bis 17,
**dadurch gekennzeichnet,**
**dass** der Durchgang (5a) nahe einer Seitenwand (31) des Stromzählergehäuses angeordnet ist.

19. Arretierung nach Anspruch 18,
**dadurch gekennzeichnet,**
**dass** das Stromzählergehäuse einen zu der Seitenwand (31) öffnenden Kanal (11a) für einen Plombierdraht aufweist.

20. Arretierung nach einem der Ansprüche 9 bis 19,
**dadurch gekennzeichnet,**
**dass** das Arretierungselement in der rückverschobenen Arretierungsposition in eine Rastvertiefung (30) einrastet oder/und zur Markierung der Arretierurigsposition ein Vorsprung gebildet ist.

21. Arretierung nach einem der Ansprüche 1 bis 20,
**dadurch gekennzeichnet,**
**dass** die Verriegelung ein in einen Aufnahmeschacht (106) am Stromzählergehäuse einsetzbares Steckschloss (107) mit einem in eine Halteposition bewegbaren, vorzugsweise verschwenkbaren, Riegelelement (125) umfasst.

22. Arretierung nach Anspruch 21,
**dadurch gekennzeichnet,**
**dass** das Riegelelement (125) in eine Ausnehmung (126) in dem Arretierungselement (105) einschwenkbar ist.

23. Arretierung nach einem der Ansprüche 1 bis 22,
**dadurch gekennzeichnet,**
**dass** das Arretierungselement einen Arretierungsstift (105) umfasst, der in einem das Gehäuse des Stromzählers durchsetzenden röhrenförmigen Führungskanal (104) angeordnet ist.

24. Arretierung nach einem der Ansprüche 1 bis 23,
**dadurch gekennzeichnet,**
**dass** der Rückzug des Arretierungselements (105) aus der Eingriffsposition eine Drehung des Arretierungselements (105) erfordert.

25. Arretierung nach einem der Ansprüche 21 bis 24,
**dadurch gekennzeichnet,**
**dass** das Riegelelement (125) zur Drehblockierung oder/und Zugblockierung des Arretierungselements (105) vorgesehen ist.

26. Arretierung nach Anspruch 24 oder 25,
**dadurch gekennzeichnet,**
**dass** die Schwenkachse (134) des Riegelelements (125) parallel zur Längsachse bzw. Drehachse (135) des Arretierungselements (105) verläuft.

27. Arretierung nach einem der Ansprüche 23 bis 25,
**dadurch gekennzeichnet,**
**dass** zwischen dem Aufnahmeschacht (106) und dem röhrenförmigen Führungskanal (104) ein gegen den Innenraum des Zählergehäuses abgeschlossener Durchgang (127) für das Riegelelement (125) gebildet ist, wobei der Aufnahmeschacht (106a) ggf. über seine gesamte Länge zu dem Führungskanal (104a) hin offen ist.

28. Arretierung nach einem der Ansprüche 23 bis 27,
**dadurch gekennzeichnet,**
**dass** von einer vorderen Wand (128) des Stromzählergehäuses ein Ansatz (129) zur Bildung des Führungskanals (104) und des Aufnahmeschachts (106) nach innen vorsteht.

29. Arretierung nach Anspruch 28,
**dadurch gekennzeichnet,**
**dass** von einer hinteren Wand (130) des Stromzählergehäuses ein Ansatz (131) zur Bildung des Führungskanals (104) und zum Verschließen des Aufnahmeschachts (106) gegen den Innenraum des Stromzählergehäuses vorsteht.

30. Arretierung nach einem der Ansprüche 21 bis 29,
**dadurch gekennzeichnet,**
**dass** der Aufnahmeschacht (106) und der Führungskanal (104) an der Vorderseite des Stromzählergehäuses innerhalb einer Einsenkung (103) an der Vorderseite des Zählergehäuses münden.
